# EUROPEAN PATENT SPECIFICATION

(11) **EP 4 556 927 B1**
(45) Date of publication and mention of the grant of the patent: **18.03.2026**
(21) Application number: 23210857.1
(22) Date of filing: 20.11.2023
(51) Int. Cl.: G01R 31/55, G01R 31/67

(54) **METHOD FOR CHECKING THE CONNECTION BETWEEN A RADIO UNIT AND AN ANTENNA ENTITY OR FUNCTIONALITY, ANTENNA ENTITY OR FUNCTIONALITY, RADIO UNIT, PROGRAM AND COMPUTER-READABLE MEDIUM**
VERFAHREN ZUR ÜBERPRÜFUNG DER VERBINDUNG ZWISCHEN EINER FUNKEINHEIT UND EINER ANTENNENEINHEIT ODER FUNKTIONALITÄT, ANTENNENEINHEIT ODER FUNKTIONALITÄT, FUNKEINHEIT, PROGRAMM UND COMPUTERLESBARES MEDIUM
PROCÉDÉ DE VÉRIFICATION DE LA CONNEXION ENTRE UNE UNITÉ RADIO ET UNE ENTITÉ OU UNE FONCTIONNALITÉ D'ANTENNE, ENTITÉ OU FONCTIONNALITÉ D'ANTENNE, UNITÉ RADIO, PROGRAMME ET SUPPORT LISIBLE PAR ORDINATEUR

(43) Date of publication of application: 21.05.2025
(73) Proprietor: Deutsche Telekom AG, 53113 Bonn (DE)
(72) Inventor: BEYER, Jürgen, 57250 Netphen (DE); KLENNER, Matthias, 53227 Bonn (DE)
(74) Representative: Schwöbel, Thilo K.

(56) References cited:
- JP-A- 2013 096 834
- US-A1- 2010 026 561
- US-A1- 2014 133 470
- US-A1- 2020 007 244
- US-A1- 2020 227 832
- US-A1- 2021 194 603

## Description

### BACKGROUND

The present invention relates a method for checking the connection between a radio unit and an antenna entity or functionality, wherein the radio unit comprises a predetermined number of output ports and generates a plurality of radiofrequency output signals to be transmitted using the output ports, wherein the antenna entity or functionality comprises a corresponding predetermined number of antenna ports receiving the radiofrequency output signals, wherein, in order to connect the radio unit with the antenna entity or functionality each output port is to be connected, by means of a feeder cable, with an antenna port, wherein the radio unit furthermore comprises a radio unit calibration port and wherein the antenna entity or functionality likewise comprises an antenna calibration port, wherein the radio unit calibration port is connected to the antenna calibration port by means of a calibration feeder cable.

Additionally, the present invention relates to an antenna entity or functionality for checking the connection between a radio unit and an antenna entity or functionality, wherein the radio unit comprises a predetermined number of output ports and generates a plurality of radiofrequency output signals to be transmitted using the output ports, wherein the antenna entity or functionality comprises a corresponding predetermined number of antenna ports receiving the radiofrequency output signals, wherein, in order to connect the radio unit with the antenna entity or functionality each output port is to be connected, by means of a feeder cable, with an antenna port, wherein the radio unit furthermore comprises a radio unit calibration port and wherein the antenna entity or functionality likewise comprises an antenna calibration port, wherein the radio unit calibration port is connected to the antenna calibration port by means of a calibration feeder cable.

Furthermore, the present invention relates to a radio unit for checking the connection between a radio unit and an antenna entity or functionality, wherein the radio unit comprises a predetermined number of output ports and generates a plurality of radiofrequency output signals to be transmitted using the output ports, wherein the antenna entity or functionality comprises a corresponding predetermined number of antenna ports receiving the radiofrequency output signals, wherein, in order to connect the radio unit with the antenna entity or functionality each output port is to be connected, by means of a feeder cable, with an antenna port, wherein the radio unit furthermore comprises a radio unit calibration port and wherein the antenna entity or functionality likewise comprises an antenna calibration port, wherein the radio unit calibration port is connected to the antenna calibration port by means of a calibration feeder cable.

Furthermore, the present invention relates to a program and to a computer-readable medium for checking the connection between a radio unit and an antenna entity or functionality according to the inventive method.

In mobile communication networks, antenna entities or functionalities, especially passive antennas, are connected by feeder cables with the respective radiofrequency signal source, e.g. a remote radio unit (RRU). The remote radio unit generates the radiofrequency signal which is transmitted over a plurality of feeder cables to the respective antenna entity or functionality or passive antenna.

However, with the advent of antenna entities or functionalities that ever higher numbers of antenna elements that are used in such antenna entities or functionalities, the correct connection between such a radio unit and such an antenna entity or functionality becomes more error-prone, due to the fact that - with a higher number of antenna elements (or radiation elements) as part of the antenna entity or functionality - there is also a higher number of output ports of the respective radio unit (corresponding to the number of antenna ports of the respective antenna entity or functionality) due to the requirement that each one of the antenna ports needs to be individually connected, by means of a feeder cable, to a corresponding output port of the radio unit.

While modern antenna entities or functionalities (e.g. passive antennas having 8 (or more) TRx ports) typically comprise a calibration port, such a calibration port is, however, not used in order to detect erroneously connected feeder cables. Documents US 2021/194603 A1 and US 2020/227832 A1 present examples of approaches for monitoring antenna connections.

### SUMMARY

An object of the present invention is to provide a technically simple, effective and cost-effective solution for checking the connection between a radio unit and an antenna entity or functionality by means of using a plurality of radiofrequency test signals. A further object of the present invention is to provide a corresponding antenna entity or functionality, a corresponding radio unit, and a corresponding program and computer-readable medium, according to claims 7, 8, 9 and 10, respectively.

The object of the present invention is achieved by a method for checking the connection between a radio unit and an antenna entity or functionality according to claim 1.

Especially by means of using different radiofrequency test signals for each one of the different (radio unit) output ports - i.e., respectively, a radiofrequency test signal having, or comprising, some signal signature, e.g. a specific frequency component and/or a specific signal amplitude or signal form during a specific time slot - it is advantageously possible, according to the present invention, to differentiate between the use of the different (radio unit) output ports, and, thus, to detect an erroneous connection, resulting, e.g. from swapping two (or more) of the feeder cables connecting the (radio unit) output ports to the antenna ports.

According to the present invention, such a test does not need to be done often or regularly (e.g. as part of an operatively used procedure, e.g. a testing or initialization procedure) as it is merely required after the feeder cables having been disconnected, either at the radio unit side (radiofrequency source side) or at the antenna entity or functionality. However, such a test or verification could, alternatively, be done regularly, especially as part of an operatively used testing or initialization procedure.

According to the present invention, the first feedback signal corresponds to the first radiofrequency test signal or a part thereof and to an indication at which one of the antenna ports the first radiofrequency test signal has been received by the antenna entity or functionality in the first step,
wherein especially the feedback signal is or corresponds to at least one out of the following:
-- the attenuated first radiofrequency test signal,
-- at least one frequency domain part of the first radiofrequency test signal,
-- at least one time domain part of the first radiofrequency test signal,
-- at least one phase domain part of the first radiofrequency test signal.

It is thereby advantageously possible to easily and efficiently implement the present invention.

According to the present invention, it is advantageously furthermore possible and preferred that the radio unit is a remote radio unit and/or wherein the antenna entity or functionality is a 4TRx antenna entity or functionality and/or a 8TRx antenna entity or functionality and/or a 16TRx antenna entity or functionality, or wherein the antenna entity or functionality has the corresponding number of antenna ports.

It is thereby advantageously possible to easily and efficiently implement the present invention.

According to the present invention, it is furthermore advantageously possible and preferred that, either during or subsequent to the first step, a second radiofrequency test signal is transmitted, by a second output port of the plurality of output ports and via a corresponding second one of the feeder cables, towards a second one of the antenna ports, wherein the antenna entity or functionality is configured such that the second radiofrequency test signal, or a part thereof, is able to be - at least temporarily - forwarded to the antenna calibration port, and wherein a second feedback signal, indicative of the second radiofrequency test signal or a part thereof, is transmitted, to the radio unit calibration port, using the calibration feeder cable.

It is thereby advantageously possible according to the present invention to realize and implement the inventive method in a comparatively simple and efficient manner.

Furthermore, it is advantageously possible and preferred according to the present invention that, for each output port except the first and second one, a separate and/or different further radiofrequency test signal is transmitted, via the corresponding feeder cable, and wherein - corresponding thereto - a separate and/or different further feedback signal is transmitted, to the radio unit calibration port, using the calibration feeder cable.

It is thereby advantageously possible according to the present invention to realize and implement the inventive method in a comparatively simple and efficient manner.

According to the present invention, it is furthermore advantageously possible and preferred that
-- the first radiofrequency test signal and the second radiofrequency test signal as well as
-- the first and second radiofrequency test signals with regard to each one of the further radiofrequency test signals and the further radiofrequency test signals among each other are different regarding at least one out of the following:
   -- at least one frequency domain part thereof,
   -- at least one time domain part thereof,
   -- at least one phase domain part thereof.

It is thereby advantageously possible according to the present invention to realize and implement the inventive method in a comparatively simple and efficient manner.

Furthermore, it is advantageously possible and preferred according to the present invention that the radio unit is configured and/or controlled such that - based on receiving the first feedback signal and/or based on receiving the second feedback signal and/or based on receiving any of the further feedback signals -
-- a correct configuration of the output ports of the radio unit - corresponding to their respective connection, via the feeder cables, to antenna ports - is performed and/or
-- a connection error is raised regarding the connection of the output ports to the antenna ports.

It is thereby advantageously possible according to the present invention to realize and implement the inventive method in a comparatively simple and efficient manner.

Furthermore, the present invention relates to an antenna entity or functionality for checking the connection between a radio unit and an antenna entity or functionality according to claim 7.

Additionally, the present invention relates to a program comprising a computer readable program code which, when executed on a computer and/or on a radio unit and/or on an antenna entity or functionality, or in part on a radio unit and/or in part on an antenna entity or functionality, causes the computer and/or the radio unit and/or the antenna entity or functionality to perform the inventive method.

Still additionally, the present invention relates to a computer-readable medium comprising instructions which when executed on a computer and/or on a radio unit and/or on an antenna entity or functionality, or in part on a radio unit and/or in part on an antenna entity or functionality, causes the computer and/or the radio unit and/or the antenna entity or functionality to perform the inventive method.

These and other characteristics, features and advantages of the present invention will become apparent from the following detailed description, taken in conjunction with the accompanying drawings, which illustrate, by way of example, the principles of the invention. The description is given for the sake of example only, without without departing from the scope of the invention, as defined in the appended claims.

### BRIEF DESCRIPTION OF THE DRAWINGS

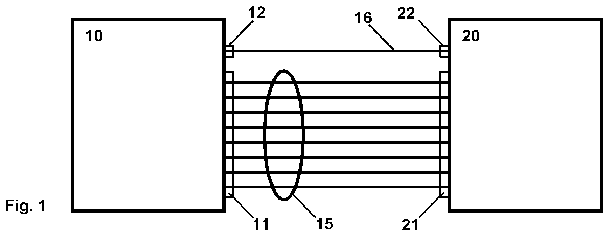

Figure 1 schematically illustrates an exemplary representation of a radio unit and an antenna entity or functionality, comprising, respectively, a certain number of (operatively used) connection ports (output ports on the radio unit side and antenna ports on the side of the antenna entity or functionality) that are connected by means of feeder cables, wherein both the radio unit and the antenna entity or functionality comprises, respectively, a calibration port.

### DETAILED DESCRIPTION

The present invention will be described with respect to particular embodiments and with reference to certain drawings, but the invention is not limited thereto but only by the claims. The drawings described are only schematic and are nonlimiting. In the drawings, the size of some of the elements may be exaggerated and not drawn on scale for illustrative purposes.

Where an indefinite or definite article is used when referring to a singular noun, e.g. "a", "an", "the", this includes a plural of that noun unless something else is specifically stated.

Furthermore, the terms first, second, third and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

In Figure 1, an exemplary representation of a radio unit 10 and an antenna entity or functionality 20 is schematically illustrated. The radio unit 10 comprises a certain - predetermined - number of output ports 11 and generates a plurality of radiofrequency output signals to be transmitted using the output ports 11. For the sake of simplicity, in Figure 1, the output ports 11 are not represented individually.

The antenna entity or functionality 20 comprises a predetermined number of antenna ports 21 (that typically corresponds to the number of output ports 11 of the radio unit 10). When operated, the antenna ports 21 are receiving the radiofrequency output signals provided by the output ports 11 by means of using feeder cables 15, and, by means of antenna radiating elements, transmit corresponding radiofrequency signals that are aimed to be received by user equipments in the vicinity of the antenna entity or functionality 20; typically, individual feeder cables 15 are used, i.e. one specific feeder cable 15 between one specific output port 11 and one specific antenna port 21, such that each output port 11 of the radio unit 10 is connected with an antenna port 21 of the antenna entity or functionality 20.

Furthermore, the radio unit 10 comprises a calibration port that is called radio unit calibration port 12, and the antenna entity or functionality 20 likewise comprises a calibration port that is called an antenna calibration port 22. The radio unit calibration port 12 is connected to the antenna calibration port 22 by means of a calibration feeder cable 16.

According to the present invention, in order to check the correct order or to check the connection of the feeder cables 15 between the radio unit 10 and the antenna entity or functionality 20, the inventive method comprises the following steps:
-- in a first step, a first radiofrequency test signal is transmitted from the radio unit by their first output port 11 and via the corresponding one of the feeder cables 15, towards one of the antenna ports 21,
-- in a second step, the antenna entity or functionality 20 is configured such that the first radiofrequency test signal, or a part thereof, is able to be - at least temporarily - forwarded to the antenna calibration port 22,
-- in a third step, a first feedback signal, indicative of the first radiofrequency test signal or a part thereof, is transmitted, to the radio unit calibration port 12, using the calibration feeder cable 16.

After the third step, the first feedback signal that is received, at the radio unit calibration port 12, in response to the first radiofrequency test signal (having been transmitted by the first output port of the radio unit 10) is able to be analyzed; especially, it is possible, according to the present invention, to determine at which one of the antenna ports 21 the first radiofrequency test signal has been received by the antenna entity or functionality 20 (i.e. which one of the antenna ports 21 the first output port is connected to).
Thereby, it is advantageously possible to detect any incorrect connections between the radio unit output ports 11 and the antenna ports 21.

Especially according to the present invention the first feedback signal corresponds to the first radiofrequency test signal or a part thereof and especially additionally comprises an indication at which one of the antenna ports 21 the first radiofrequency test signal has been received by the antenna entity or functionality 20 in the first step. Especially the feedback signal is or corresponds to at least one out of the following:
-- the attenuated first radiofrequency test signal,
-- at least one frequency domain part of the first radiofrequency test signal,
-- at least one time domain part of the first radiofrequency test signal,
-- at least one time domain part of the first radiofrequency test signal.

According to the present invention, it is especially furthermore preferred that regarding all the other ones of the output ports 11, the same steps (as regarding the first radiofrequency test signal being transmitted from the first one of the output ports 11) are performed, either simultaneously, i.e. during the first step, or sequentially, i.e. each radiofrequency test signal separately, i.e. in a time-separated manner. Hence - regarding the second one of the output ports 11 -, either during or subsequent to the first step, a second radiofrequency test signal is transmitted, by the second output port of the plurality of output ports 11 and via a corresponding second one of the feeder cables 15, towards a second one of the antenna ports 21, wherein the antenna entity or functionality 20 is configured such that the second radiofrequency test signal, or a part thereof, is able to be - at least temporarily - forwarded to the antenna calibration port 22, and wherein a second feedback signal, indicative of the second radiofrequency test signal or a part thereof, is transmitted, to the radio unit calibration port 12, using the calibration feeder cable 16.
Likewise especially, for each further output port of the plurality of output ports 11 (i.e. except the first and second one), a separate and/or different further radiofrequency test signal is transmitted, via the corresponding feeder cable 15, and - corresponding thereto - a separate and/or different further feedback signal is transmitted, to the radio unit calibration port 12, using the calibration feeder cable 16.
Hence especially - also regarding the other output ports 11 -, it is possible, according to the present invention, to determine at which one of the antenna ports 21 the first, second, third, etc. radiofrequency test signal has been received by the antenna entity or functionality 20 (i.e. which one of the antenna ports 21 the first, second, third, etc. output port is connected to).

It is especially preferred, according to the present invention, that the radiofrequency test signals that are used for the different output ports 11 are different, i.e. for each one of the output ports 11, a separate and/or different further radiofrequency test signal is transmitted, via the corresponding feeder cable 15, and - corresponding thereto - a separate and/or different further feedback signal is transmitted, to the radio unit calibration port 12, using the calibration feeder cable 16.
The different radiofrequency test signals especially differ regarding at least one out of the following:
-- at least one frequency domain part thereof,
-- at least one time domain part thereof,
-- at least one phase domain part thereof.
Otherwise said, according to the present invention, each one of the different radiofrequency test signals (used for the plurality of output ports 11 and to check their correct connection to the respective antenna ports) is unique among these test signals, i.e. there is - for each one thereof - at least one frequency domain part and/or a time domain part and/or a phase domain part where the considered radiofrequency test signal differs from all the other test signals.

This especially allows to detect such differences, and - together with the information or indication (as part of the respective first, second, third, etc. feedback signal) at which one of the antenna ports 21 the respective considered radiofrequency test signal has actually been received by the antenna entity or functionality 20 - to control the radio unit 10 such that, based on receiving the first feedback signal and/or based on receiving the second feedback signal and/or based on receiving any of the further feedback signals,
-- a correct configuration of the output ports 11 of the radio unit 10 - corresponding to their respective connection, via the feeder cables 15, to antenna ports 21 - is performed and/or
-- a connection error is raised regarding the connection of the output ports 11 to the antenna ports 21 (in case such connection is incorrect).

Especially according to the present invention, the radio unit 10 is a remote radio unit and/or the antenna entity or functionality is a 4TRx antenna entity or functionality and/or a 8TRx antenna entity or functionality and/or a 16TRx antenna entity or functionality, or wherein the antenna entity or functionality has the corresponding number of antenna ports.

Hence, according to the present invention, a solution is able to be provided for the following scenario:
A radio unit 10 and an antenna entity or functionality 20 is to be connected; per antenna TRx port, one feeder cable is needed, which means, e.g., that passive antennas with 8 TRx have 8 feeder cables. Typically, multi-layer systems in 4G or 5G networks have strict requirements regarding the order of the antenna ports in the passive antenna. This is typically expected by the radiofrequency source (i.e. the radio unit 10) as well as by the UE (i.e. the user equipment that is receiving a radiofrequency signal radiated from one or a plurality of antenna elements of the antenna entity or functionality 20) for proper radiating and receiving the signal. In order to keep this strict requirement, the 8 (or more) output ports 11 of the radiofrequency source, i.e. the radio unit 10, have to be connected in a strict order with the 8 (or more) antenna input ports 21. If one feeder cable (or more feeder cables) 15 are erroneously connected, the signal radiated from the antenna does not have the desired properties regarding antenna pattern and MIMO (multiple input multiple output technology). This might lead to significant performance and coverage reduction. Modern passive antennas with 8 (or more) TRx typically contain a calibration port 22. This is a radiofrequency cable (or port), typically close to the end of the eight (or more) feeder cables, that inside the antenna entity or functionality 20 is connecting the antenna radiofrequency connector (or antenna port) with the antenna radiating elements. Presently, this calibration port 22 (or these calibration ports 22, 12) enable(s) or is/are used to correct the signal phase between radiofrequency source output and antenna radiation elements such that an equal signal phase at the antenna radiation elements is able to be achieved. This is also a requirement for proper signal transmission via four, eight (or even more) TRx antenna entities or functionalities.

In presently used systems, such calibration port is, however, not able to detect erroneously connected feeder cables 15.

According to the present invention, this is able to be done by extending the use of the calibration port system. For that purpose, a unique test signal (unique per output port) of the radiofrequency source is transmitted (by the radio unit 10 to the antenna entity or functionality 20). The unique test signal has a unique signature, e.g. in time domain, frequency domain or phase domain.

The unique test signal is transmitted by one of the output ports 11 (e.g. the first output port) of the radio unit 10 (or radiofrequency source), and it is expected at the corresponding antenna port (e.g. a first antenna connector, such as, e.g. a first port or aport A). Internally of the antenna entity or functionality 20, the signal received at the respective antenna port is forwarded, or provided, - at least partly - to the calibration port 22 , especially shortly before it is feed to one antenna radiation element or to a group of antenna radiation elements. Assuming radiofrequency test signal differentiation in the frequency domain, this radiofrequency test signal has, e.g. a frequency or signal component at a frequency f₁. If the antenna calibration port 22feeds back (to the radio unit calibration port 12) the received signal at frequency f₁, the calibration system (at the radio unit 10) knows that the feeder connection is correct. If it feeds back any other of the test signal frequencies, the system knows that the feeder connection is not correct. Moreover, due to the unique signature of the four, eight or sixteen (or more) test signals, the system knows which radiofrequency source output port is connected to which antenna connector (or antenna port), and erroneous feeder connections can be corrected by means of correspondingly configuring the radio unit 20, especially remotely by software.

According to the present invention, such a test procedure has not to be done regularly; it is only required after the feeder cables 15 are disconnected from either the antenna entity or functionality 20 or from the radiofrequency source side, i.e. the radio unit 10.

## Claims

1. Method for checking the connection between a radio unit (10) and an antenna entity or functionality (20), wherein the radio unit (10) comprises a predetermined number of output ports (11) and generates a plurality of radiofrequency output signals to be transmitted using the output ports (11), wherein the antenna entity or functionality (20) comprises a corresponding predetermined number of antenna ports (21) receiving the radiofrequency output signals, wherein, in order to connect the radio unit (10) with the antenna entity or functionality (20) each output port (11) is to be connected, by means of a feeder cable (15), with an antenna port (21),
wherein the radio unit (10) furthermore comprises a radio unit calibration port (12) and wherein the antenna entity or functionality (20) likewise comprises an antenna calibration port (22), wherein the radio unit calibration port (12) is connected to the antenna calibration port (22) by means of a calibration feeder cable (16),
wherein, in order to check the correct order or the connection of the feeder cables (15) between the radio unit (10) and the antenna entity or functionality (20), the method comprises the following steps:
-- in a first step, a first radiofrequency test signal is transmitted from the radio unit by a first one of the output ports (11) and via the corresponding one of the feeder cables (15), towards one of the antenna ports (21),
-- in a second step, the antenna entity or functionality (20) is configured such that the first radiofrequency test signal, or a part thereof, is able to be - at least temporarily - forwarded to the antenna calibration port (22),
-- in a third step, a first feedback signal, indicative of the first radiofrequency test signal or a part thereof, is transmitted, to the radio unit calibration port (12), using the calibration feeder cable (16);
wherein the first feedback signal corresponds to the first radiofrequency test signal or a part thereof and to an indication at which one of the antenna ports (21) the first radiofrequency test signal has been received by the antenna entity or functionality (20) in the first step,
wherein especially the feedback signal is or corresponds to at least one out of the following:
-- the attenuated first radiofrequency test signal,
-- at least one frequency domain part of the first radiofrequency test signal,
-- at least one time domain part of the first radiofrequency test signal,
-- at least one phase domain part of the first radiofrequency test signal.

2. Method according to one of the preceding claims, wherein the radio unit (10) is a remote radio unit and/or wherein the antenna entity or functionality is a 4TRx antenna entity or functionality and/or a 8TRx antenna entity or functionality and/or a 16TRx antenna entity or functionality, or wherein the antenna entity or functionality has the corresponding number of antenna ports.

3. Method according to one of the preceding claims, wherein, either during or subsequent to the first step, a second radiofrequency test signal is transmitted, by a second output port of the plurality of output ports (11) and via a corresponding second one of the feeder cables (15), towards a second one of the antenna ports (21), wherein the antenna entity or functionality (20) is configured such that the second radiofrequency test signal, or a part thereof, is able to be - at least temporarily - forwarded to the antenna calibration port (22), and wherein a second feedback signal, indicative of the second radiofrequency test signal or a part thereof, is transmitted, to the radio unit calibration port (12), using the calibration feeder cable (16).

4. Method according to one of the preceding claims, wherein, for each output port (11), a separate and/or different further radiofrequency test signal is transmitted, via the corresponding feeder cable (15), and wherein - corresponding thereto - a separate and/or different further feedback signal is transmitted, to the radio unit calibration port (12), using the calibration feeder cable (16).

5. Method according to one of the preceding claims, wherein
-- the first radiofrequency test signal and the second radiofrequency test signal,
-- as well as the first and second radiofrequency test signals with regard to each one of the further radiofrequency test signals and the further radiofrequency test signals among each other
are different regarding at least one out of the following:
-- at least one frequency domain part thereof,
-- at least one time domain part thereof,
-- at least one phase domain part thereof.

6. Method according to one of the preceding claims, wherein the radio unit is configured and/or controlled such that - based on receiving the first feedback signal and/or based on receiving the second feedback signal and/or based on receiving any of the further feedback signals -
-- a correct configuration of the output ports (11) of the radio unit (10) - corresponding to their respective connection, via the feeder cables (15), to antenna ports (21) - is performed and/or
-- a connection error is raised regarding the connection of the output ports (11) to the antenna ports (21).

7. Antenna entity or functionality (20) for checking the connection between a radio unit (10) and an antenna entity or functionality (20), wherein the radio unit (10) comprises a predetermined number of output ports (11) and is configured to generate a plurality of radiofrequency output signals to be transmitted using the output ports (11), wherein the antenna entity or functionality (20) comprises a corresponding predetermined number of antenna ports (21) for receiving the radiofrequency output signals, wherein, in order to connect the radio unit (10) with the antenna entity or functionality (20) each output port (11) is to be connected, by means of a feeder cable (15), with an antenna port (21),
wherein the radio unit (10) furthermore comprises a radio unit calibration port (12) and wherein the antenna entity or functionality (20) likewise comprises an antenna calibration port (22), wherein the radio unit calibration port (12) is connected to the antenna calibration port (22) by means of a calibration feeder cable (16),
wherein, in order to check the connection of the feeder cables (15) between the radio unit (10) and the antenna entity or functionality (20), the antenna entity or functionality (20) is configured such that:
-- a first radiofrequency test signal is received, via the corresponding one of the feeder cables (15), at one of the antenna ports (21),
-- the antenna entity or functionality (20) is configured such that the first radiofrequency test signal, or a part thereof, is able to be - at least temporarily - forwarded to the antenna calibration port (22),
-- a first feedback signal, indicative of the first radiofrequency test signal or a part thereof, is transmitted, to the radio unit calibration port (12), using the calibration feeder cable (16);
wherein the first feedback signal corresponds to the first radiofrequency test signal or a part thereof and to an indication at which one of the antenna ports (21) the first radiofrequency test signal has been received by the antenna entity or functionality (20) in the first step,
wherein especially the feedback signal is or corresponds to at least one out of the following:
-- the attenuated first radiofrequency test signal,
-- at least one frequency domain part of the first radiofrequency test signal,
-- at least one time domain part of the first radiofrequency test signal,
-- at least one phase domain part of the first radiofrequency test signal.

8. Radio unit (10) for checking the connection between a radio unit (10) and an antenna entity or functionality (20), wherein the radio unit (10) comprises a predetermined number of output ports (11) and is configured to generate a plurality of radiofrequency output signals to be transmitted using the output ports (11), wherein the antenna entity or functionality (20) comprises a corresponding predetermined number of antenna ports (21) for receiving the radiofrequency output signals, wherein, in order to connect the radio unit (10) with the antenna entity or functionality (20) each output port (11) is to be connected, by means of a feeder cable (15), with an antenna port (21),
wherein the radio unit (10) furthermore comprises a radio unit calibration port (12) and wherein the antenna entity or functionality (20) likewise comprises an antenna calibration port (22), wherein the radio unit calibration port (12) is connected to the antenna calibration port (22) by means of a calibration feeder cable (16),
wherein, in order to check the connection of the feeder cables (15) between the radio unit (10) and the antenna entity or functionality (20), the radio unit (10) is configured such that:
-- a first radiofrequency test signal is transmitted, by the first output port (11) and via the corresponding one of the feeder cables (15), towards one of the antenna ports (21),
-- a first feedback signal, indicative of the first radiofrequency test signal or a part thereof, is received, from the radio unit calibration port (12), using the calibration feeder cable (16);
wherein the first feedback signal corresponds to the first radiofrequency test signal or a part thereof and to an indication at which one of the antenna ports (21) the first radiofrequency test signal has been received by the antenna entity or functionality (20) in the first step,
wherein especially the feedback signal is or corresponds to at least one out of the following:
-- the attenuated first radiofrequency test signal,
-- at least one frequency domain part of the first radiofrequency test signal,
-- at least one time domain part of the first radiofrequency test signal,
-- at least one phase domain part of the first radiofrequency test signal.

9. Program comprising a computer readable program code, which, when executed on a radio unit (10) and/or on an antenna entity or functionality (20), or in part on a radio unit (10) and/or in part on an antenna entity or functionality (20), causes the computer and/or the radio unit (10) and/or the antenna entity or functionality (20) to perform a method according one of claims 1 to 6.

10. Computer-readable medium, which, when executed on radio unit (10) and/or on an antenna entity or functionality (20), or in part on a radio unit (10) and/or in part on an antenna entity or functionality (20), causes the computer and/or the radio unit (10) and/or the antenna entity or functionality (20) to perform a method according one of claims 1 to 6.

## Patentansprüche

1. Verfahren zur Überprüfung der Verbindung zwischen einer Funkeinheit (10) und einer Antennenentität oder Antennenfunktionalität (20), wobei die Funkeinheit (10) eine vorbestimmte Anzahl von Ausgangsports (11) umfasst und eine Mehrzahl von Hochfrequenz-Ausgangssignalen erzeugt, die unter Verwendung der Ausgangsports (11) zu übertragen sind, wobei die Antennenentität oder Antennenfunktionalität (20) eine entsprechende vorbestimmte Anzahl von Antennenports (21) umfasst, die die Hochfrequenz-Ausgangssignale empfangen, wobei zum Verbinden der Funkeinheit (10) mit der Antennenentität oder Antennenfunktionalität (20) jeder Ausgangsport (11) mittels eines Speisekabels (15) mit einem Antennenport (21) zu verbinden ist,
wobei die Funkeinheit (10) ferner einen Funkeinheit-Kalibrierungsport (12) umfasst und wobei die Antennenentität oder Antennenfunktionalität (20) ebenfalls einen Antennen-Kalibrierungsport (22) umfasst, wobei der Funkeinheit-Kalibrierungsport (12) mittels eines Kalibrierungs-Speisekabels (16) mit dem Antennen-Kalibrierungsport (22) verbunden ist,
wobei das Verfahren, um die korrekte Reihenfolge oder die Verbindung der Speisekabel (15) zwischen der Funkeinheit (10) und der Antennenentität oder Antennenfunktionalität (20) zu überprüfen, die folgenden Schritte umfasst:
- in einem ersten Schritt wird ein erstes Hochfrequenz-Testsignal von der Funkeinheit durch einen ersten der Ausgangsports (11) und über das entsprechende der Speisekabel (15) zu einem der Antennenports (21) übertragen,
- in einem zweiten Schritt wird die Antennenentität oder Antennenfunktionalität (20) so konfiguriert, dass das erste Hochfrequenz-Testsignal oder ein Teil davon - zumindest temporär - an den Antennen-Kalibrierungsport (22) weitergeleitet werden kann,
- in einem dritten Schritt wird ein erstes Rückkopplungssignal, das das erste Hochfrequenz-Testsignal oder einen Teil davon anzeigt, unter Verwendung des Kalibrierungs-Speisekabels (16) zum Funkeinheit-Kalibrierungsport (12) übertragen;
wobei das erste Rückkopplungssignal dem ersten Hochfrequenz-Testsignal oder einem Teil davon entspricht und einer Anzeige entspricht, an welchem der Antennenports (21) das erste Hochfrequenz-Testsignal von der Antennenentität oder Antennenfunktionalität (20) im ersten Schritt empfangen wurde,
wobei insbesondere das Rückkopplungssignal mindestens eines der folgenden ist oder entspricht:
- das gedämpfte erste Hochfrequenz-Testsignal,
- mindestens ein Frequenzbereich-Teil des ersten Hochfrequenz-Testsignals,
- mindestens ein Zeitbereich-Teil des ersten Hochfrequenz-Testsignals,
- mindestens ein Phasenbereich-Teil des ersten Hochfrequenz-Testsignals.

2. Verfahren nach einem der vorhergehenden Ansprüche, wobei die Funkeinheit (10) eine Remote-Funkeinheit ist und/oder wobei die Antennenentität oder Antennenfunktionalität eine 4TRx-Antennenentität oder -Antennenfunktionalität und/oder eine 8TRx-Antennenentität oder -Antennenfunktionalität und/oder eine 16TRx-Antennenentität oder -Antennenfunktionalität ist, oder wobei die Antennenentität oder Antennenfunktionalität die entsprechende Anzahl von Antennenports aufweist.

3. Verfahren nach einem der vorhergehenden Ansprüche, wobei entweder während oder nach dem ersten Schritt ein zweites Hochfrequenz-Testsignal von einem zweiten Ausgangsport der Mehrzahl von Ausgangsports (11) und über ein entsprechendes zweites der Speisekabel (15) zu einem zweiten der Antennenports (21) übertragen wird, wobei die Antennenentität oder Antennenfunktionalität (20) so konfiguriert ist, dass das zweite Hochfrequenz-Testsignal oder ein Teil davon - zumindest temporär - an den Antennen-Kalibrierungsport (22) weitergeleitet werden kann, und wobei ein zweites Rückkopplungssignal, das das zweite Hochfrequenz-Testsignal oder einen Teil davon anzeigt, unter Verwendung des Kalibrierungs-Speisekabels (16) zum Funkeinheit-Kalibrierungsport (12) übertragen wird.

4. Verfahren nach einem der vorhergehenden Ansprüche, wobei für jeden Ausgangsport (11) ein separates und/oder unterschiedliches weiteres Hochfrequenz-Testsignal über das entsprechende Speisekabel (15) übertragen wird, und wobei - entsprechend dazu - ein separates und/oder unterschiedliches weiteres Rückkopplungssignal unter Verwendung des Kalibrierungs-Speisekabels (16) zum Funkeinheit-Kalibrierungsport (12) übertragen wird.

5. Verfahren nach einem der vorhergehenden Ansprüche, wobei
- das erste Hochfrequenz-Testsignal und das zweite Hochfrequenz-Testsignal,
- sowie das erste und zweite Hochfrequenz-Testsignal in Bezug auf jedes der weiteren Hochfrequenz-Testsignale und die weiteren Hochfrequenz-Testsignale untereinander
sich hinsichtlich mindestens eines der folgenden unterscheiden:
- mindestens ein Frequenzbereich-Teil davon,
- mindestens ein Zeitbereich-Teil davon,
- mindestens ein Phasenbereich-Teil davon.

6. Verfahren nach einem der vorhergehenden Ansprüche, wobei die Funkeinheit so konfiguriert und/oder gesteuert ist, dass - basierend auf dem Empfang des ersten Rückkopplungssignals und/oder basierend auf dem Empfang des zweiten Rückkopplungssignals und/oder basierend auf dem Empfang eines der weiteren Rückkopplungssignale -
- eine korrekte Konfiguration der Ausgangsports (11) der Funkeinheit (10) - entsprechend ihrer jeweiligen Verbindung über die Speisekabel (15) zu Antennenports (21) - durchgeführt wird und/oder
- ein Verbindungsfehler bezüglich der Verbindung der Ausgangsports (11) zu den Antennenports (21) ausgegeben wird.

7. Antennenentität oder Antennenfunktionalität (20) zur Überprüfung der Verbindung zwischen einer Funkeinheit (10) und einer Antennenentität oder Antennenfunktionalität (20), wobei die Funkeinheit (10) eine vorbestimmte Anzahl von Ausgangsports (11) umfasst und konfiguriert ist, eine Mehrzahl von Hochfrequenz-Ausgangssignalen zu erzeugen, die unter Verwendung der Ausgangsports (11) zu übertragen sind, wobei die Antennenentität oder Antennenfunktionalität (20) eine entsprechende vorbestimmte Anzahl von Antennenports (21) zum Empfangen der Hochfrequenz-Ausgangssignale umfasst, wobei zum Verbinden der Funkeinheit (10) mit der Antennenentität oder Antennenfunktionalität (20) jeder Ausgangsport (11) mittels eines Speisekabels (15) mit einem Antennenport (21) zu verbinden ist,
wobei die Funkeinheit (10) ferner einen Funkeinheit-Kalibrierungsport (12) umfasst und wobei die Antennenentität oder Antennenfunktionalität (20) ebenfalls einen Antennen-Kalibrierungsport (22) umfasst, wobei der Funkeinheit-Kalibrierungsport (12) mittels eines Kalibrierungs-Speisekabels (16) mit dem Antennen-Kalibrierungsport (22) verbunden ist,
wobei die Antennenentität oder Antennenfunktionalität (20), um die Verbindung der Speisekabel (15) zwischen der Funkeinheit (10) und der Antennenentität oder Antennenfunktionalität (20) zu überprüfen, so konfiguriert ist, dass:
- ein erstes Hochfrequenz-Testsignal über das entsprechende der Speisekabel (15) an einem der Antennenports (21) empfangen wird,
- die Antennenentität oder Antennenfunktionalität (20) so konfiguriert ist, dass das erste Hochfrequenz-Testsignal oder ein Teil davon - zumindest temporär - an den Antennen-Kalibrierungsport (22) weitergeleitet werden kann,
- ein erstes Rückkopplungssignal, das das erste Hochfrequenz-Testsignal oder einen Teil davon anzeigt, unter Verwendung des Kalibrierungs-Speisekabels (16) zum Funkeinheit-Kalibrierungsport (12) übertragen wird;
wobei das erste Rückkopplungssignal dem ersten Hochfrequenz-Testsignal oder einem Teil davon entspricht und einer Anzeige entspricht, an welchem der Antennenports (21) das erste Hochfrequenz-Testsignal von der Antennenentität oder Antennenfunktionalität (20) im ersten Schritt empfangen wurde,
wobei insbesondere das Rückkopplungssignal mindestens eines der folgenden ist oder entspricht:
- das gedämpfte erste Hochfrequenz-Testsignal,
- mindestens ein Frequenzbereich-Teil des ersten Hochfrequenz-Testsignals,
- mindestens ein Zeitbereich-Teil des ersten Hochfrequenz-Testsignals,
- mindestens ein Phasenbereich-Teil des ersten Hochfrequenz-Testsignals.

8. Funkeinheit (10) zur Überprüfung der Verbindung zwischen einer Funkeinheit (10) und einer Antennenentität oder Antennenfunktionalität (20), wobei die Funkeinheit (10) eine vorbestimmte Anzahl von Ausgangsports (11) umfasst und konfiguriert ist, eine Mehrzahl von Hochfrequenz-Ausgangssignalen zu erzeugen, die unter Verwendung der Ausgangsports (11) zu übertragen sind, wobei die Antennenentität oder Antennenfunktionalität (20) eine entsprechende vorbestimmte Anzahl von Antennenports (21) zum Empfangen der Hochfrequenz-Ausgangssignale umfasst, wobei zum Verbinden der Funkeinheit (10) mit der Antennenentität oder Antennenfunktionalität (20) jeder Ausgangsport (11) mittels eines Speisekabels (15) mit einem Antennenport (21) zu verbinden ist,
wobei die Funkeinheit (10) ferner einen Funkeinheit-Kalibrierungsport (12) umfasst und wobei die Antennenentität oder Antennenfunktionalität (20) ebenfalls einen Antennen-Kalibrierungsport (22) umfasst, wobei der Funkeinheit-Kalibrierungsport (12) mittels eines Kalibrierungs-Speisekabels (16) mit dem Antennen-Kalibrierungsport (22) verbunden ist,
wobei die Funkeinheit (10), um die Verbindung der Speisekabel (15) zwischen der Funkeinheit (10) und der Antennenentität oder Antennenfunktionalität (20) zu überprüfen, so konfiguriert ist, dass:
- ein erstes Hochfrequenz-Testsignal vom ersten Ausgangsport (11) und über das entsprechende der Speisekabel (15) zu einem der Antennenports (21) übertragen wird,
- ein erstes Rückkopplungssignal, das das erste Hochfrequenz-Testsignal oder einen Teil davon anzeigt, vom Funkeinheit-Kalibrierungsport (12) unter Verwendung des Kalibrierungs-Speisekabels (16) empfangen wird;
wobei das erste Rückkopplungssignal dem ersten Hochfrequenz-Testsignal oder einem Teil davon entspricht und einer Anzeige entspricht, an welchem der Antennenports (21) das erste Hochfrequenz-Testsignal von der Antennenentität oder Antennenfunktionalität (20) im ersten Schritt empfangen wurde,
wobei insbesondere das Rückkopplungssignal mindestens eines der folgenden ist oder entspricht:
- das gedämpfte erste Hochfrequenz-Testsignal,
- mindestens ein Frequenzbereich-Teil des ersten Hochfrequenz-Testsignals,
- mindestens ein Zeitbereich-Teil des ersten Hochfrequenz-Testsignals,
- mindestens ein Phasenbereich-Teil des ersten Hochfrequenz-Testsignals.

9. Programm, das einen computerlesbaren Programmcode umfasst, der, wenn er auf einer Funkeinheit (10) und/oder auf einer Antennenentität oder Antennenfunktionalität (20) oder teilweise auf einer Funkeinheit (10) und/oder teilweise auf einer Antennenentität oder Antennenfunktionalität (20) ausgeführt wird, den Computer und/oder die Funkeinheit (10) und/oder die Antennenentität oder Antennenfunktionalität (20) veranlasst, ein Verfahren nach einem der Ansprüche 1 bis 6 durchzuführen.

10. Computerlesbares Medium, das, wenn es auf einer Funkeinheit (10) und/oder auf einer Antennenentität oder Antennenfunktionalität (20) oder teilweise auf einer Funkeinheit (10) und/oder teilweise auf einer Antennenentität oder Antennenfunktionalität (20) ausgeführt wird, den Computer und/oder die Funkeinheit (10) und/oder die Antennenentität oder Antennenfunktionalität (20) veranlasst, ein Verfahren nach einem der Ansprüche 1 bis 6 durchzuführen.

## Revendications

1. Procédé de vérification de la connexion entre une unité radio (10) et une entité d'antenne ou fonctionnalité d'antenne (20), dans lequel l'unité radio (10) comprend un nombre prédéterminé de ports de sortie (11) et génère une pluralité de signaux de sortie radiofréquence à transmettre en utilisant les ports de sortie (11), dans lequel l'entité d'antenne ou fonctionnalité d'antenne (20) comprend un nombre prédéterminé correspondant de ports d'antenne (21) recevant les signaux de sortie radiofréquence, dans lequel, afin de connecter l'unité radio (10) avec l'entité d'antenne ou fonctionnalité d'antenne (20), chaque port de sortie (11) doit être connecté, au moyen d'un câble d'alimentation d'antenne (15), avec un port d'antenne (21),
dans lequel l'unité radio (10) comprend en outre un port de calibration d'unité radio (12) et dans lequel l'entité d'antenne ou fonctionnalité d'antenne (20) comprend également un port de calibration d'antenne (22), dans lequel le port de calibration d'unité radio (12) est connecté au port de calibration d'antenne (22) au moyen d'un câble de liaison de calibration (16),
dans lequel, afin de vérifier l'ordre correct ou la connexion des câbles d'alimentation (15) entre l'unité radio (10) et l'entité d'antenne ou fonctionnalité d'antenne (20), le procédé comprend les étapes suivantes :
- dans une première étape, un premier signal de test radiofréquence est transmis depuis l'unité radio par un premier des ports de sortie (11) et via le câble d'alimentation d'antenne (15) correspondant, vers l'un des ports d'antenne (21),
- dans une deuxième étape, l'entité d'antenne ou fonctionnalité d'antenne (20) est configurée de telle sorte que le premier signal de test radiofréquence, ou une partie de celui-ci, puisse être - au moins temporairement - transmis au port de calibration d'antenne (22),
- dans une troisième étape, un premier signal de rétroaction, indicatif du premier signal de test radiofréquence ou d'une partie de celui-ci, est transmis, au port de calibration d'unité radio (12), en utilisant le câble de liaison de calibration (16) ;
dans lequel le premier signal de rétroaction correspond au premier signal de test radiofréquence ou à une partie de celui-ci et à une indication de lequel des ports d'antenne (21) le premier signal de test radiofréquence a été reçu par l'entité d'antenne ou fonctionnalité d'antenne (20) dans la première étape,
dans lequel en particulier le signal de rétroaction est ou correspond à au moins l'un des éléments suivants :
- le premier signal de test radiofréquence atténué,
- au moins une partie en domaine fréquentiel du premier signal de test radiofréquence,
- au moins une partie en domaine temporel du premier signal de test radiofréquence,
- au moins une partie en domaine de phase du premier signal de test radiofréquence.

2. Procédé selon l'une des revendications précédentes, dans lequel l'unité radio (10) est une unité radio distante et/ou dans lequel l'entité d'antenne ou fonctionnalité d'antenne est une entité d'antenne ou fonctionnalité d'antenne 4TRx et/ou une entité d'antenne ou fonctionnalité d'antenne 8TRx et/ou une entité d'antenne ou fonctionnalité d'antenne 16TRx, ou dans lequel l'entité d'antenne ou fonctionnalité d'antenne possède le nombre correspondant de ports d'antenne.

3. Procédé selon l'une des revendications précédentes, dans lequel, soit pendant ou après la première étape, un deuxième signal de test radiofréquence est transmis, par un deuxième port de sortie de la pluralité de ports de sortie (11) et via un deuxième câble d'alimentation d'antenne (15) correspondant, vers un deuxième des ports d'antenne (21), dans lequel l'entité d'antenne ou fonctionnalité d'antenne (20) est configurée de telle sorte que le deuxième signal de test radiofréquence, ou une partie de celui-ci, puisse être - au moins temporairement - transmis au port de calibration d'antenne (22), et dans lequel un deuxième signal de rétroaction, indicatif du deuxième signal de test radiofréquence ou d'une partie de celui-ci, est transmis, au port de calibration d'unité radio (12), en utilisant le câble de liaison de calibration (16).

4. Procédé selon l'une des revendications précédentes, dans lequel, pour chaque port de sortie (11), un signal de test radiofréquence supplémentaire séparé et/ou différent est transmis, via le câble d'alimentation d'antenne (15) correspondant, et dans lequel - en correspondance - un signal de rétroaction supplémentaire séparé et/ou différent est transmis, au port de calibration d'unité radio (12), en utilisant le câble de liaison de calibration (16).

5. Procédé selon l'une des revendications précédentes, dans lequel
- le premier signal de test radiofréquence et le deuxième signal de test radiofréquence,
- ainsi que les premier et deuxième signaux de test radiofréquence par rapport à chacun des signaux de test radiofréquence supplémentaires et les signaux de test radiofréquence supplémentaires entre eux
sont différents concernant au moins l'un des éléments suivants :
- au moins une partie en domaine fréquentiel de celui-ci,
- au moins une partie en domaine temporel de celui-ci,
- au moins une partie en domaine de phase de celui-ci.

6. Procédé selon l'une des revendications précédentes, dans lequel l'unité radio est configurée et/ou contrôlée de telle sorte que - sur la base de la réception du premier signal de rétroaction et/ou sur la base de la réception du deuxième signal de rétroaction et/ou sur la base de la réception de l'un des signaux de rétroaction supplémentaires -
- une configuration correcte des ports de sortie (11) de l'unité radio (10) - correspondant à leur connexion respective, via les câbles d'alimentation d'antenne (15), aux ports d'antenne (21) - est effectuée et/ou
- une erreur de connexion est signalée concernant la connexion des ports de sortie (11) aux ports d'antenne (21).

7. Entité d'antenne ou fonctionnalité d'antenne (20) pour vérifier la connexion entre une unité radio (10) et une entité d'antenne ou fonctionnalité d'antenne (20), dans laquelle l'unité radio (10) comprend un nombre prédéterminé de ports de sortie (11) et est configurée pour générer une pluralité de signaux de sortie radiofréquence à transmettre en utilisant les ports de sortie (11), dans laquelle l'entité d'antenne ou fonctionnalité d'antenne (20) comprend un nombre prédéterminé correspondant de ports d'antenne (21) pour recevoir les signaux de sortie radiofréquence, dans laquelle, afin de connecter l'unité radio (10) avec l'entité d'antenne ou fonctionnalité d'antenne (20), chaque port de sortie (11) doit être connecté, au moyen d'un câble d'alimentation d'antenne (15), avec un port d'antenne (21),
dans laquelle l'unité radio (10) comprend en outre un port de calibration d'unité radio (12) et dans laquelle l'entité d'antenne ou fonctionnalité d'antenne (20) comprend également un port de calibration d'antenne (22), dans laquelle le port de calibration d'unité radio (12) est connecté au port de calibration d'antenne (22) au moyen d'un câble de liaison de calibration (16),
dans laquelle, afin de vérifier la connexion des câbles d'alimentation d'antenne (15) entre l'unité radio (10) et l'entité d'antenne ou fonctionnalité d'antenne (20), l'entité d'antenne ou fonctionnalité d'antenne (20) est configurée de telle sorte que :
- un premier signal de test radiofréquence est reçu, via le câble d'alimentation d'antenne (15) correspondant, à l'un des ports d'antenne (21),
- l'entité d'antenne ou fonctionnalité d'antenne (20) est configurée de telle sorte que le premier signal de test radiofréquence, ou une partie de celui-ci, puisse être - au moins temporairement - transmis au port de calibration d'antenne (22),
- un premier signal de rétroaction, indicatif du premier signal de test radiofréquence ou d'une partie de celui-ci, est transmis, au port de calibration d'unité radio (12), en utilisant le câble de liaison de calibration (16) ;
dans laquelle le premier signal de rétroaction correspond au premier signal de test radiofréquence ou à une partie de celui-ci et à une indication de lequel des ports d'antenne (21) le premier signal de test radiofréquence a été reçu par l'entité d'antenne ou fonctionnalité d'antenne (20) dans la première étape,
dans laquelle en particulier le signal de rétroaction est ou correspond à au moins l'un des éléments suivants :
- le premier signal de test radiofréquence atténué,
- au moins une partie en domaine fréquentiel du premier signal de test radiofréquence,
- au moins une partie en domaine temporel du premier signal de test radiofréquence,
- au moins une partie en domaine de phase du premier signal de test radiofréquence.

8. Unité radio (10) pour vérifier la connexion entre une unité radio (10) et une entité d'antenne ou fonctionnalité d'antenne (20), dans laquelle l'unité radio (10) comprend un nombre prédéterminé de ports de sortie (11) et est configurée pour générer une pluralité de signaux de sortie radiofréquence à transmettre en utilisant les ports de sortie (11), dans laquelle l'entité d'antenne ou fonctionnalité d'antenne (20) comprend un nombre prédéterminé correspondant de ports d'antenne (21) pour recevoir les signaux de sortie radiofréquence, dans laquelle, afin de connecter l'unité radio (10) avec l'entité d'antenne ou fonctionnalité d'antenne (20), chaque port de sortie (11) doit être connecté, au moyen d'un câble d'alimentation d'antenne (15), avec un port d'antenne (21),
dans laquelle l'unité radio (10) comprend en outre un port de calibration d'unité radio (12) et dans laquelle l'entité d'antenne ou fonctionnalité d'antenne (20) comprend également un port de calibration d'antenne (22), dans laquelle le port de calibration d'unité radio (12) est connecté au port de calibration d'antenne (22) au moyen d'un câble de liaison de calibration (16),
dans laquelle, afin de vérifier la connexion des câbles d'alimentation d'antenne (15) entre l'unité radio (10) et l'entité d'antenne ou fonctionnalité d'antenne (20), l'unité radio (10) est configurée de telle sorte que :
- un premier signal de test radiofréquence est transmis, par le premier port de sortie (11) et via le câble d'alimentation d'antenne (15) correspondant, vers l'un des ports d'antenne (21),
- un premier signal de rétroaction, indicatif du premier signal de test radiofréquence ou d'une partie de celui-ci, est reçu, du port de calibration d'unité radio (12), en utilisant le câble de liaison de calibration (16) ;
dans laquelle le premier signal de rétroaction correspond au premier signal de test radiofréquence ou à une partie de celui-ci et à une indication de lequel des ports d'antenne (21) le premier signal de test radiofréquence a été reçu par l'entité d'antenne ou fonctionnalité d'antenne (20) dans la première étape,
dans laquelle en particulier le signal de rétroaction est ou correspond à au moins l'un des éléments suivants :
- le premier signal de test radiofréquence atténué,
- au moins une partie en domaine fréquentiel du premier signal de test radiofréquence,
- au moins une partie en domaine temporel du premier signal de test radiofréquence,
- au moins une partie en domaine de phase du premier signal de test radiofréquence.

9. Programme comprenant un code de programme lisible par ordinateur qui, lorsqu'il est exécuté sur une unité radio (10) et/ou sur une entité d'antenne ou fonctionnalité d'antenne (20), ou en partie sur une unité radio (10) et/ou en partie sur une entité d'antenne ou fonctionnalité d'antenne (20), amène l'ordinateur et/ou l'unité radio (10) et/ou l'entité d'antenne ou fonctionnalité d'antenne (20) à exécuter un procédé selon l'une des revendications 1 à 6.

10. Support lisible par ordinateur qui, lorsqu'il est exécuté sur une unité radio (10) et/ou sur une entité d'antenne ou fonctionnalité d'antenne (20), ou en partie sur une unité radio (10) et/ou en partie sur une entité d'antenne ou fonctionnalité d'antenne (20), amène l'ordinateur et/ou l'unité radio (10) et/ou l'entité d'antenne ou fonctionnalité d'antenne (20) à exécuter un procédé selon l'une des revendications 1 à 6.
